# EUROPEAN PATENT APPLICATION

(11) **EP 4 842 198 A2**
(43) Date of publication of application: **18.11.2026**
(21) Application number: 26178563.8
(22) Date of filing: 13.05.2026
(51) Int. Cl.: H10W 90/10, H10W 70/60, H10W 70/62, H10W 70/63, H10W 74/01, H10W 74/15

(54) **SEMICONDUCTOR PACKAGE STRUCTURE**

(30) Priority: 13.05.2025 US 202563804717 P; 23.03.2026 US 202619574750
(71) Applicant: MediaTek Inc., Hsinchu City 30078 (TW)
(72) Inventor: CHEN, Wei-Yu, 30078 Hsinchu City (TW); LIU, Nai-Wei, 30078 Hsinchu City (TW); CHIU, Sang-Mao, 30078 Hsinchu City (TW); CHEN, Chi-Yuan, 30078 Hsinchu City (TW); TSAI, Yi-Lin, 30078 Hsinchu City (TW); LIN, Shih-Chin, 30078 Hsinchu City (TW)
(74) Representative: Haseltine Lake Kempner LLP

(57) **Abstract**

A semiconductor package structure is provided. The semiconductor package structure includes a substrate, a bridge structure, a first semiconductor die, a first memory component, and a second memory component. The bridge structure is embedded in the substrate. The bridge structure includes a first bridge unit and a second bridge unit disposed over the first bridge unit. The first semiconductor die is disposed over the substrate and overlaps the bridge structure. The first memory component is disposed over the substrate and overlaps the bridge structure, and it is adjacent to the first semiconductor die. The second memory component is disposed over the substrate and overlaps the bridge structure, and it is adjacent to the first memory component.

## Description

### CROSS REFERENCE TO RELATED APPLICATIONS

This application claims the benefit of U.S. provisional application No. 63/804,717, filed May 13, 2025, the entirety of which is incorporated by reference herein.

### TECHNICAL FIELD

The present disclosure relates to a semiconductor package structure, and, in particular, it relates to a package structure for integrating logic dies with memory components.

### BACKGROUND

In advanced semiconductor packaging, high-performance logic chips such as system-on-chips (SoCs) increasingly rely on high-bandwidth memory (HBM) or other types of DRAM to support data-intensive computing tasks. In conventional package architectures, however, the physical area available around an SoC for placing and routing connections to multiple memory devices is limited. This constraint restricts the number of memory units that can be arranged in proximity to the SoC and correspondingly limits the amount of memory that can be electrically coupled to the logic die.

Various approaches have been proposed to increase interconnect capacity between logic and memory, including the use of redistribution layers, interposers, and bridge structures. However, when the physical footprint around the SoC remains the primary region for memory placement and routing, the total number of memory devices that can be accommodated is restricted. This limitation may impede the overall compute throughput, as the system's effective performance depends on the amount or bandwidth of memory that is accessible to the logic chip.

In view of these challenges, there remains a need for package structures that can provide additional routing or placement capability, such that a logic chip may be interconnected with a greater quantity of memory devices and support increased compute performance.

### BRIEF SUMMARY

In accordance with some embodiments of the present disclosure, a semiconductor package structure is provided. The semiconductor package structure includes a substrate, a bridge structure, a first semiconductor die, a first memory component, and a second memory component. The bridge structure is embedded in the substrate. The bridge structure includes a first bridge unit and a second bridge unit disposed over the first bridge unit. The first semiconductor die is disposed over the substrate and overlaps the bridge structure. The first memory component is disposed over the substrate and overlaps the bridge structure, and it is adjacent to the first semiconductor die. The second memory component is disposed over the substrate and overlaps the bridge structure, and it is adjacent to the first memory component.

In accordance with some other embodiments of the present disclosure, a semiconductor package structure is provided. The semiconductor package structure includes a substrate, an interposer, a bridge structure, a first semiconductor die, a first memory component, and a second memory component. The interposer is disposed over the substrate. The bridge structure is embedded in the interposer. The bridge structure includes a first bridge unit and a second bridge unit disposed over the first bridge unit. The first semiconductor die is disposed over the interposer and overlaps the bridge structure. The first memory component is disposed over the interposer and overlaps the bridge structure, and it is adjacent to the first semiconductor die. The second memory component is disposed over the interposer and overlaps the bridge structure, and it is adjacent to the first memory component.

In accordance with still some other embodiments of the present disclosure, a semiconductor package structure is provided. The semiconductor package structure includes a substrate, an interposer, a bridge structure, a first semiconductor die, a first memory component, and a second memory component. The interposer is disposed over the substrate. The interposer includes a first layer and a second layer disposed over the first layer. The bridge structure is embedded in the interposer. The bridge structure includes a first bridge unit and a second bridge unit respectively disposed in the first layer and the second layer. The first semiconductor die is disposed over the interposer and overlaps the bridge structure. The first memory component is disposed over the interposer and overlaps the bridge structure, and it is adjacent to the first semiconductor die. The second memory component is disposed over the interposer and overlaps the bridge structure, and it is adjacent to the first memory component.

A detailed description is given in the following embodiments with reference to the accompanying drawings.

### BRIEF DESCRIPTION OF THE DRAWINGS

The disclosure may be more fully understood by reading the subsequent detailed description and examples with references made to the accompanying drawings, wherein:
FIG. 1 is a cross-sectional diagram of an exemplary semiconductor package structure in accordance with some embodiments of the present disclosure;
FIG. 2A, FIG. 2B and FIG. 2C are enlarged diagrams of area R1 in FIG. 1 including the bridge structure of an exemplary semiconductor package structure in accordance with some embodiments of the present disclosure;
FIG. 3 is a cross-sectional diagram of an exemplary semiconductor package structure in accordance with some embodiments of the present disclosure;
FIG. 4A, FIG. 4B and FIG. 4C are enlarged diagrams of area R2 in FIG.3 including the bridge structure of an exemplary semiconductor package structure in accordance with some embodiments of the present disclosure;
FIG. 5 is a cross-sectional diagram of an exemplary semiconductor package structure in accordance with some embodiments of the present disclosure;
FIG. 6A and FIG. 6B are enlarged diagrams of area R3 in FIG.5 including the bridge structure of an exemplary semiconductor package structure in accordance with some embodiments of the present disclosure;
FIGs. 7A to 7D are cross-sectional diagrams of an exemplary semiconductor package structure during the manufacturing processes in accordance with some embodiments of the present disclosure.

### DETAILED DESCRIPTION

The semiconductor package structure according to the present disclosure is described in detail in the following description. It should be understood that in the following detailed description, for purposes of explanation, numerous specific details and embodiments are set forth in order to provide a thorough understanding of the present disclosure. The elements and configurations described in the following detailed description are set forth in order to clearly describe the present disclosure. These embodiments are used merely for the purpose of illustration, and the present disclosure is not limited thereto. In addition, different embodiments may use like and/or corresponding numerals to denote like and/or corresponding elements in order to clearly describe the present disclosure. However, the use of like and/or corresponding numerals of different embodiments does not suggest any correlation between different embodiments.

It should be understood that relative expressions may be used in the embodiments. For example, "lower", "bottom", "higher" or "top" are used to describe the position of one element relative to another. It should be appreciated that if a device is flipped upside down, an element that is "lower" will become an element that is "higher". The present disclosure can be understood by referring to the following detailed description in connection with the accompanying drawings. The drawings are also regarded as part of the description of the present disclosure. It should be understood that the drawings of the present disclosure may be not drawn to scale. In fact, the size of the elements may be arbitrarily enlarged or reduced to clearly represent the features of the present disclosure.

Furthermore, the expression "a first material layer is disposed on or over a second material layer" may indicate that the first material layer is in direct contact with the second material layer, or it may indicate that the first material layer is in indirect contact with the second material layer. In the situation where the first material layer is in indirect contact with the second material layer, there may be one or more intermediate layers between the first material layer and the second material layer. However, the expression "the first material layer is directly disposed on or over the second material layer" means that the first material layer is in direct contact with the second material layer, and there is no intermediate element or layer between the first material layer and the second material layer.

Moreover, it should be understood that the ordinal numbers used in the specification and claims, such as the terms "first", "second", etc., are used to modify an element, which itself does not mean and represent that the element (or elements) has any previous ordinal number, and does not mean the order of a certain element and another element, or the order in the manufacturing method. The use of these ordinal numbers is to make an element with a certain name can be clearly distinguished from another element with the same name. Claims and the specification may not use the same terms. For example, the first element in the specification may be understood by referring to the second element in the claims.

In the following descriptions, terms "about", "substantially" and "approximately" typically mean +/- 10% of the stated value, or typically +/- 5% of the stated value, or typically +/- 3% of the stated value, or typically +/- 2% of the stated value, or typically +/- 1% of the stated value or typically +/- 0.5% of the stated value. The expression "between the first value and the second value" means that the range includes the first value, the second value, and other values in between.

Unless defined otherwise, all technical and scientific terms used herein have the same meaning as commonly understood by one of ordinary skill in the art to which this disclosure belongs. It should be appreciated that, in each case, the term, which is defined in a commonly used dictionary, should be interpreted as having a meaning that conforms to the relative skills of the present disclosure and the background or the context of the present disclosure, and should not be interpreted in an idealized or overly formal manner unless so defined.

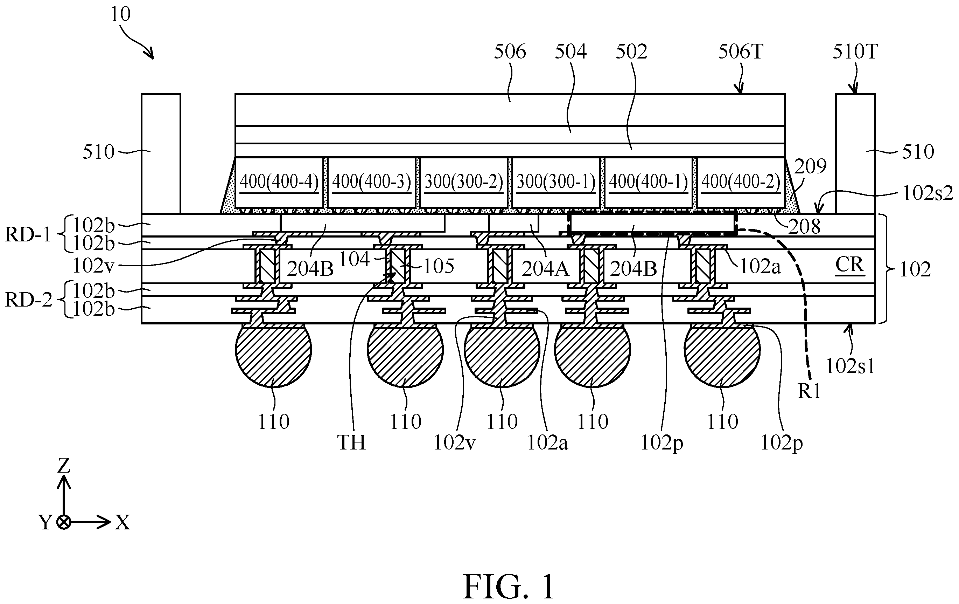

Please refer to FIG. 1, which is a cross-sectional diagram of an exemplary semiconductor package structure 10 in accordance with some embodiments of the present disclosure. It should be understood that some elements of the semiconductor package structure 10 may be omitted in the figure for clarity, and only some elements are schematically illustrated. In accordance with some embodiments, additional features may be added to the semiconductor package structure 10 described below. In accordance with some other embodiments, some features of the semiconductor package structure 10 described below may be replaced or omitted.

The semiconductor package structure 10 can be used to form a package requiring high-power operation, such as flip chip ball grid array (FCBGA), land grid array (LGA), a fan-out semiconductor package, a two-dimensional (2D) semiconductor package, a 2.5D semiconductor package, a three-dimensional (3D) semiconductor package, a 3.5D semiconductor package, or another suitable package. In accordance with some embodiments, the 2.5D or 3D semiconductor package can be a Chip-on-Wafer-on-Substrate (CoWoS) structure, for example, a CoWoS-L structure. As shown in FIG. 1, the semiconductor package structure 10 may include a substrate 102, a bridge structure 204A, a bridge structure 204B, a semiconductor die 300 (including semiconductor dies 300-1 and 300-2), and a memory component 400 (including memory components 400-1, 400-2, 400-3 and 400-4).

As shown in FIG. 1, the substrate 102 may include a multi-layered package substrate. The substrate 102 may provide mechanical support and electrical connections between integrated circuit (IC) chips and conductive bumps attached to the top surface 102s2 and bottom surface 102s1 of the substrate 102. The substrate 102 may have various types including, for example, a core substrate or a coreless substrate. The core substrate includes thin core, thick core (e.g., laminate BT (bismaleimide-triazine resin) or FR-4 type fibrous board material), and laminate core. Alternatively, the cored package substrates, for example, can be built up layer by layer around a central core, with layers of conductive material (usually copper) separated by layers of insulating dielectric, with interlayer connections being formed with through holes or vias (microvias).

In accordance with some embodiment, as shown in FIG. 1, the substrate 102 includes a core CR and redistribution layers (RDLs) RD-1 and RD-2. In accordance with some embodiments, the core CR may be formed of an organic material, a glass material, a ceramic material, a semiconductor material, the like, or a combination thereof. The organic material may include polypropylene, prepreg (PP), fiberglass resin (e.g., FR-4), bismaleimide triazine (BT) resin, the like, or a combination thereof. The semiconductor material may include silicon, germanium, or a compound material, including silicon germanium, silicon carbide, gallium arsenic, silicon germanium carbide, the like, or a combination thereof. The redistribution layers RD-1 and RD-2 are disposed on the top surface and the bottom surface of the core CR, respectively. In accordance with some embodiments, each of the redistribution layers RD-1 and RD-2 includes conductive layers 102a, vias 102v disposed in one or more dielectric layers 102b, and conductive pads 102p.

In accordance with some embodiments, the dielectric layers 102b of the redistribution layers RD-1 and RD-2 are symmetrically disposed the top surface and the bottom surface of the core CR. For example, the number of dielectric layers 102b of the redistribution layer RD-1 may be the same as the number of dielectric layers 102b of the redistribution layers RD-2. In accordance with some embodiments, the dielectric layers 102b may be formed of organic polymer, including polyimide (PI), polybenzoxazole (PBO), benzocyclobutene (BCB), epoxy, Ajinomoto build-up film (ABF), Bismaleimide-Triazine (BT resin), another suitable organic dielectric material, or a combination thereof, but it is not limited thereto. Alternatively, the dielectric layers 102b may be formed of silicon oxide, silicon nitride, silicon oxynitride, the like, or a combination thereof. In accordance with some embodiments, the dielectric layers 102b may be formed by a lamination process, a spin coating process, a chemical vapor deposition (CVD) process, or another applicable process. In accordance with some embodiment, the dielectric layers 102b may be patterned through one or more photolithography processes and/or etching processes.

It should be noted that the number of vias 102v, the number of conductive layers 102a and the number of dielectric layers 102b of the redistribution layers RD-1 and RD-2 shown in FIG. 1 are an example and the present disclosure is not limited thereto.

As shown in FIG. 1, the substrate 102 has separated holes TH (or through holes TH) embedded therein. In accordance with some embodiments, the holes TH are formed to pass through the core CR, which is embedded in the substrate 102. In accordance with some embodiments, the holes TH are formed by a drilling process (e.g., mechanical drilling).

The conductive material 104 is disposed in the hole TH. In accordance with some embodiments, as shown in FIG. 1, the conductive material 104 may be formed as a thin conductive layer lining inner walls of the hole TH. The conductive material 104 in the hole TH may have a hollow pillar shape. In accordance with some embodiments, the conductive material 104 include copper or nickel-copper and are formed by a plating process, such as chemical plating, electroplating or electro-less plating. For example, the conductive material 104 may also be called a plated through hole (PTHs).

As shown in FIG. 1, the substrate 102 of the semiconductor package structure 10 further includes a filling material 105 filling the remaining space of the hole TH and surrounded by the conductive material 104. In accordance with some embodiments, the filling material 105 may include a non-conductive material such as epoxy resin, or an ink. In accordance with some other embodiments, the filling material 105 may include a conductive material such as copper.

The conductive layers 102a are formed within the dielectric layers 102b at different levels. Some of the conductive layers 102a are formed directly on the top surface and the bottom surface of the core CR, respectively. In accordance with some embodiments, the conductive layers 102a may fully cover the holes TH, the conductive material 104 lining the inner walls of the holes TH, and the filling material 105 filling the holes TH. In addition, the conductive layers 102a may be electrically connected (coupled) to the conductive material 104 lining the inner walls of the holes TH.

In accordance with some embodiments, the conductive layers 102a at each of levels of the redistribution layers RD-1 and RD-2 may include a set of conductive traces (not shown) or conductive planes (also called ground planes) (not shown). In accordance with some embodiments, the conductive traces may include power trace segments, signal trace segments or ground trace segments, which are used for the input/output (I/O) connections of the semiconductor dies 300.

As shown in FIG. 1, the vias 102v are disposed in the dielectric layers 102b of the redistribution layers RD-1 and RD-2. The vias 102v may be formed passing through the dielectric layers 102b of the redistribution layers RD-1 and RD-2 to be coupled to different levels of the conductive layers 102a. In accordance with some embodiments, the vias 102v may be formed by laser-drilling and a subsequent deposition process.

The conductive pads 102p are exposed to openings of solder mask layers (not shown) disposed close to the top surface 102s2 and the bottom surface 102s1 of the substrate 102. The conductive pads 102p are coupled to different terminals of the conductive traces. The conductive pads 102p close to the bottom surface 102s1 of the substrate 102 may be coupled to the conductive structures 110, and the conductive structures 110 may be mounted directly on the conductive pads 102p.

In accordance with some embodiments, the conductive layers 102a, the vias 102v and the conductive pads 102p include a conductive material, such as metals including copper, gold, silver, or other applicable metals. For example, the conductive layers 102a, the vias 102v and the conductive pads 102p may be formed of copper.

The substrate 102 may be coupled to an external electronic component through the conductive structures 110. In accordance with some embodiments, the external electronic component may include a printed circuit board (PCB), a chip, a control component or another electronic component, but it is not limited thereto. In accordance with some embodiments, the conductive structures 110 include a conductive ball structure such as a copper ball, a conductive bump structure such as a copper bump or a solder bump structure, or a conductive pillar structure such as a copper pillar structure.

Moreover, in accordance with some embodiments, the semiconductor package structure 10 further includes one or more passive components (not shown) disposed within the substrate 102. For example, the passive components may be embedded in the core CR of the substrate 102. The passive components may be coupled to the redistribution layer RD-1. In accordance with some embodiments, the passive component may include a resistor, a capacitor, an inductor, or another suitable passive component. In accordance with some embodiments, the passive component may be a deep trench capacitor (DTC).

In accordance with some embodiments, the semiconductor package structure 10 further includes one or more passive components (not shown) disposed below the substrate 102. The passive components may be disposed on the bottom surface 102s1 of the substrate 102 and adjacent to the conductive structures 110. In accordance with some embodiments, the passive component may include a resistor, a capacitor, an inductor, or another suitable passive component. In accordance with some embodiments, the passive component may be a land side capacitor (LSC).

As shown in FIG. 1, one or more bridge structures 204A and 204B are embedded in the substrate 102. In accordance with some embodiments, the bridge structures 204A and 204B are embedded in the upper portion of the substrate 102. For example, the bridge structures 204A and 204B may be positioned in the redistribution layer RD-1 and embedded in the dielectric layers 102b. In accordance with some embodiments, the bridge structures 204A and 204B may be disposed in recesses (not shown) formed in the upper portion of the substrate 102. The bridge structure 204A may vertically overlap the semiconductor dies 300, that is, the bridge structure 204A may overlap the semiconductor dies 300 in the normal direction of the substrate 102 (e.g., the Z direction in the figure). For example, the bridge structure 204A may vertically overlap both the semiconductor dies 300-1 and 300-2. The bridge structure 204B may overlap the semiconductor die 300 and the memory components 400 in the normal direction of the substrate 102. For example, the bridge structure 204B may vertically overlap the semiconductor die 300-1, the memory component 400-1 and the memory component 400-2. The bridge structure 204B may vertically overlap the semiconductor die 300-2, the memory component 400-3 and the memory component 400-4.

The bridge structure 204A may be coupled between the semiconductor dies 300. For example, the bridge structure 204A may be coupled between the semiconductor dies 300-1 and 300-2. In other words, the semiconductor die 300-1 may be coupled to the semiconductor die 300-2 through the bridge structure 204A. The bridge structure 204B may be coupled between the semiconductor die 300 and two memory components 400. In particular, the bridge structure 204B may be coupled between the semiconductor die 300-1 and the memory component 400-1, and between the semiconductor die 300-1 and the memory component 400-2. The bridge structure 204B may be coupled between the semiconductor die 300-2 and the memory component 400-3, and between the semiconductor die 300-2 and the memory component 400-4. In other words, the semiconductor die 300-1 may be respectively coupled to the memory components 400-1 and 400-2 through the bridge structure 204B. The semiconductor die 300-2 may be respectively coupled to the memory components 400-3 and 400-4 through the bridge structure 204B. Moreover, the bridge structures 204A and 204B may be coupled to the conductive layers 102a of the redistribution layer RD-1. Specifically, the bridge structures 204A and 204B may include interconnection layers that are coupled to redistribution layer RD-1 through vias or other applicable conductive structures.

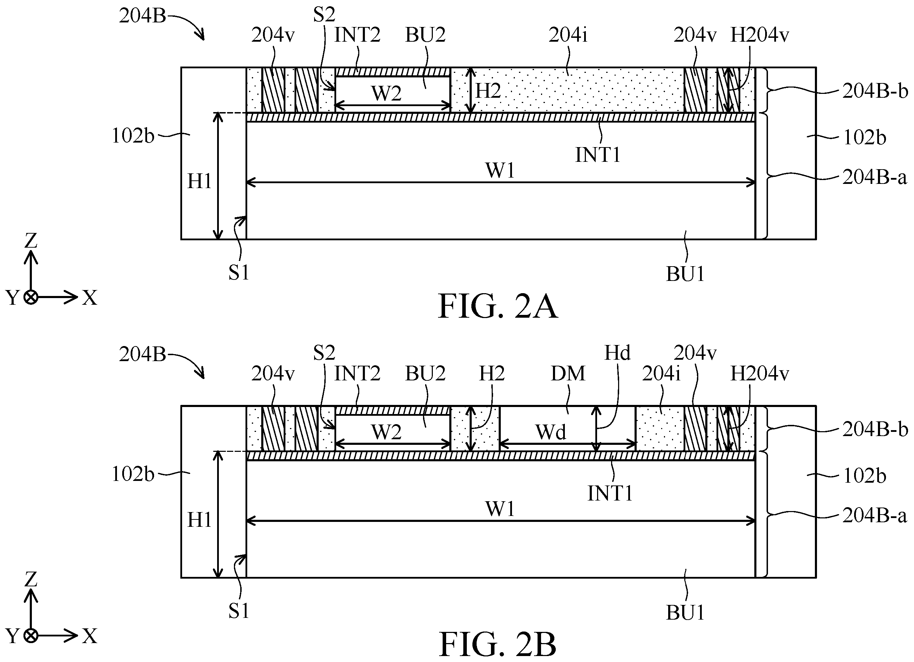

In accordance with some embodiments, the bridge structures 204A and 204B may be bridge dies. Specifically, the bridge die may include a silicon body and an interconnect structure embedded in the silicon body. The interconnect structure may include interconnection layers (e.g., conductive traces and vias) disposed in one or more dielectric layers, and conductive pads formed in or on the silicon body. The interconnect structure may electrically couple the semiconductor dies 300 to each other, or electrically couple the semiconductor die 300 to the memory component 400. In accordance with some embodiments, the bridge structures 204A and 204B may be local silicon interconnects (LSIs). In particular, the bridge structure 204B may be a multi-layer bridge structure, which can increase the number of memory components 400 that can be electrically connected to the semiconductor die 300. The detailed configuration of the multi-layer bridge structure 204B is provided in the following descriptions with reference to FIGs. 2A to 2C.

As shown in FIG. 1, the semiconductor package structure 10 includes semiconductor dies 300 (including semiconductor dies 300-1 and 300-2) disposed over the substrate 102 and overlapping the bridge structures 204A and 204B. The semiconductor die 300-2 is disposed adjacent to the semiconductor die 300-1. The semiconductor dies 300 are arranged side-by-side in a direction perpendicular to the normal direction of the substrate 102 (e.g., the X direction in the figure). In accordance with some embodiments, the semiconductor dies 300 are mounted on the substrate 102 by a bonding process using conductive connectors 208. The semiconductor dies 300 overlap the bridge structures 204A and 204B in the normal direction of the substrate 102. Specifically, both the semiconductor dies 300-1 and 300-2 may vertically overlap the bridge structure 204A. The semiconductor die 300-1 may vertically overlap the bridge structure 204A and the bridge structure 204B. The semiconductor die 300-2 may vertically overlap the bridge structure 204A and the bridge structure 204B. Moreover, the semiconductor die 300 and the memory components 400 may overlap one bridge structure 204B in the normal direction of the substrate 102. For example, the semiconductor die 300-1, the memory component 400-1 and the memory component 400-2 may vertically overlap one bridge structure 204B. The semiconductor die 300-2, the memory component 400-3 and the memory component 400-4 may vertically overlap one bridge structure 204B.

The semiconductor dies 300 may be logic dies. In accordance with some embodiments, each of the semiconductor dies 300 (including semiconductor dies 300-1 and 300-2) independently includes one or more system-on-chip (SoC) dies, system-on-integrated-circuits (SoIC) dies, the like, or any combination thereof. For example, the semiconductor dies 300 may each independently include one or more application specific integrated circuit (ASIC) dies, SoIC-X dies, Foveros dies, application processor (AP) dies, central processing unit (CPU) dies, graphics processing unit (GPU) dies, micro control unit (MCU) dies, microprocessor unit (MPU) dies, the like, or any combination thereof. In particular embodiments, the semiconductor dies 300 may include one or more SoC dies. In accordance with some embodiments, the semiconductor dies 300-1 and 300-2 may have different functions.

In accordance with some embodiments, the conductive connectors 208 include a conductive ball structure such as a copper ball, a conductive bump structure such as a copper bump or a solder bump structure, or a conductive pillar structure such as a copper pillar structure. For example, the conductive connectors 208 may be microbumps, controlled collapse chip connection (C4) bumps, solder balls, ball grid array (BGA) balls, another suitable conductive connector, or a combination thereof.

As shown in FIG. 1, the semiconductor package structure 10 includes the memory components 400 disposed over the substrate 102 and overlapping the bridge structure 204B. Specifically, the memory component 400-1 and the memory component 400-2 overlap the bridge structure 204B. The memory component 400-1 is adjacent to the semiconductor die 300-1, and the memory component 400-2 is adjacent to the memory component 400-1. Similarly, the memory component 400-3 and the memory component 400-4 overlap the bridge structure 204B. The memory component 400-3 is adjacent to the semiconductor die 300-2, and the memory component 400-4 is adjacent to the memory component 400-3. The semiconductor die 300-1 may be respectively coupled to the memory components 400-1 and 400-2 through the bridge structure 204B. The semiconductor die 300-2 may be respectively coupled to the memory components 400-3 and 400-4 through the bridge structure 204B.

In accordance with some embodiments, each of the memory components 400-1, 400-2, 400-3 and 400-4 may be a high-bandwidth memory (HBM). The high-bandwidth memory may include a base die (not shown) and a plurality of memory dies (not shown) stacked thereon, but it is not limited thereto. The base die may include a dynamic random access memory (DRAM) controller die. In addition, each of memory dies may be a dynamic random-access memory (DRAM) die. In accordance with some embodiments, the memory dies may be hybrid bonded each other and interconnected through conductive vias. For example, each of the memory dies may include one or more conductive vias. The conductive vias may be through-silicon vias (TSVs). In accordance with some embodiments, the conductive via may be formed of metal, such as copper, tungsten, tantalum, titanium, another suitable conductive material, an alloy thereof, or a combination thereof, but it is not limited thereto.

It should be noted that the number of bridge structures 204A and 204B, the number of semiconductor dies 300, the number of memory components 400 of the semiconductor package structure 10 shown in FIG. 1 are an example and the present disclosure is not limited thereto.

Refer to FIG. 2A, which is an enlarged diagram of area R1 in FIG. 1 including the bridge structure 204B of the exemplary semiconductor package structure 10 in accordance with some embodiments of the present disclosure. The bridge structure 204B may be a multi-layer bridge structure. As shown in FIG. 2A, the bridge structure 204B includes a first bridge unit BU1 and a second bridge unit BU2 disposed over the first bridge unit BU1. The first bridge unit BU1 and the second bridge unit BU2 each may be a bridge die. Specifically, in accordance with some embodiments, the bridge structure 204B has a first layer 204B-a and a second layer 204B-b disposed over the first layer 204B-a, the first bridge unit BU1 is positioned in the first layer 204B-a, and the second bridge unit BU2 is positioned in the second layer 204B-b. The second bridge unit BU2 overlaps the first bridge unit BU1 in the normal direction of the of the substrate 102. In accordance with some embodiments, the first bridge unit BU1 overlaps the semiconductor die 300-1, the memory component 400-1, and the memory component 400-2 in the normal direction of the of the substrate 102. In accordance with some embodiments, the second bridge unit BU2 vertically overlaps the semiconductor die 300-1, the memory component 400-1, and the memory component 400-2. In accordance with some other embodiments, the second bridge unit BU2 vertically overlaps the semiconductor die 300-1 and the memory component 400-1, but not the memory component 400-2.

In accordance with some embodiments, the first bridge unit BU1 has a dimension greater than that of the second bridge unit BU2. In accordance with some other embodiments, the first bridge unit BU1 has a dimension substantially the same as that of the second bridge unit BU2. Specifically, the first bridge unit BU1 has a width W1 and a height H1, and the second bridge unit BU2 has a width W2 and a height H2. In accordance with some embodiments, the width W1 of the first bridge unit BU1 is greater than width W2 of the second bridge unit BU2. In accordance with some embodiments, the height H1 of the first bridge unit BU1 is greater than height H2 of the second bridge unit BU2. In accordance with some embodiments, the height H1 of the first bridge unit BU1 is substantially the same as the height H2 of the second bridge unit BU2. The aforementioned widths W1 and W2 may respectively refer to the maximum widths of the first bridge unit BU1 and the second bridge unit BU2 along a direction perpendicular to the normal direction of the substrate 102. The aforementioned heights H1 and H2 may respectively refer to the maximum heights of the first bridge unit BU1 and the second bridge unit BU2 along the normal direction of the substrate 102. Moreover, in accordance with some embodiments, the side surface S1 of the first bridge unit BU1 may protrude outward relative to the side surface S2 of the second bridge unit BU2.

In accordance with some embodiments, the first bridge unit BU1 includes an interconnect structure INT1. The interconnect structure INT1 may include one or more interconnection layers (e.g., conductive traces and vias) disposed within one or more dielectric layers, and conductive pads formed in or on a silicon body. In accordance with some embodiments, the second bridge unit BU2 includes an interconnect structure INT2. The interconnect structure INT2 may include one or more interconnection layers (e.g., conductive traces and vias) disposed within one or more dielectric layers, and conductive pads formed in or on a silicon body.

In accordance with some embodiments, the bridge structure 204B further includes one or more conductive vias 204v positioned in the second layer 204B-b, and the semiconductor die 300-1 is coupled to the first bridge unit BU1 through the conductive via 204v. In accordance with some embodiments, the bridge structure 204B further includes a dielectric material 204i surrounding the second bridge unit BU2, and the conductive via 204v penetrates the dielectric material 204i. In other words, the conductive via 204v may be a through-dielectric-via. The conductive vias 204v may be spaced apart by the dielectric material 204i. The second bridge unit BU2 and the conductive via 204v may also be spaced apart by the dielectric material 204i. In accordance with some embodiments, the height H204v of the conductive via 204v is substantially the same as the height H2 of the second bridge unit BU2. The height H204v may refer to the maximum height of the conductive via 204v along the normal direction of the substrate 102.

The conductive via 204v may be formed of metal, such as copper, tungsten, tantalum, titanium, another suitable conductive material, an alloy thereof, or a combination thereof, but it is not limited thereto. In accordance with some embodiments, the conductive via 204v may be formed by a physical vapor deposition (PVD) process, an electroplating process, an electroless plating process, or another applicable process. Moreover, one or more photolithography processes and/or etching processes may be used to formed the conductive via 204v.

The dielectric material 204i may be formed of inorganic dielectric material, such as silicon oxide, silicon nitride, silicon oxynitride, the like, or a combination thereof, but it is not limited thereto. In accordance with some embodiments, the dielectric material 204i may be formed by a lamination process, a spin coating process, a chemical vapor deposition (CVD) process, or another applicable process. Moreover, one or more photolithography processes and/or etching processes may be used to form the dielectric material 204i.

The semiconductor die 300 may be respectively coupled to more than one memory components 400 through different bridge units positioned in the first layer 204B-a and the second layer 204B-b. For example, the semiconductor die 300-1 may be coupled to the memory component 400-1 through the second bridge unit BU2, and the semiconductor die 300-1 may be coupled to the memory component 400-2 through the first bridge unit BU1. For example, the semiconductor die 300-2 may be coupled to the memory component 400-3 through the second bridge unit BU2, and the semiconductor die 300-2 may be coupled to the memory component 400-4 through the first bridge unit BU1. More specifically, the semiconductor die 300-1 may be coupled to the memory component 400-1 through the interconnect structure INT2 of the second bridge unit BU2. The semiconductor die 300-1 may be coupled to the memory component 400-2 through the conductive vias 204v and the interconnect structure INT1 of the first bridge unit BU1. Similarly, the semiconductor die 300-2 may be coupled to the memory component 400-3 through the interconnect structure INT2 of the second bridge unit BU2. The semiconductor die 300-2 may be coupled to the memory component 400-4 through the conductive vias 204v and the interconnect structure INT1 of the first bridge unit BU1.

It should be noted that the bridge structure may include more than two layers or may adopt a configuration having more than two bridge units, in accordance with some embodiments. Such flexibility in the architecture of the bridge structure allows the interconnect density and routing capability to be increased without significantly enlarging the footprint of the interposer or substrate. Accordingly, the semiconductor die 300 can be electrically coupled to additional memory components 400 through the multi-layer or multi-unit bridge structure. This enables the semiconductor package structure to accommodate a greater quantity of memory components, which can be used to support higher-capacity or higher-bandwidth operation in computing applications.

The first bridge unit BU1 and the second bridge unit BU2 may be bonded together through a chip-on-wafer process, and then a singulation process may be performed to separate the bonded structure into individual units. In accordance with some embodiments, the chip-on-wafer process may include a hybrid bonding process. Specifically, the chip-on-wafer process may include a hybrid bonding process in which individual semiconductor dies are bonded to a target wafer. In such embodiments, the bonding is performed at a die-to-wafer level, and the bonding interface may include dielectric-to-dielectric bonding and metal-to-metal bonding between corresponding bonding pads or interconnect features. In accordance with some embodiments, the singulation process may include forming a plurality of cutting lanes on the wafer surface, followed by removing material along the cutting lanes using a mechanical saw, a laser dicing process, a plasma dicing process, or a combination thereof. The dielectric material 204i then may be formed over the first bridge unit BU1 and surrounding the second bridge unit BU2. The conductive vias 204v then may be formed to penetrate the dielectric material 204i. Thereafter, the multi-layer bridge structure 204B may be embedded in the dielectric layer 102b of the redistribution layer RD-1 (as shown in FIG. 1).

Referring to FIG. 2B, which is an enlarged diagram of area R1 in FIG. 1 including the bridge structure 204B of the exemplary semiconductor package structure 10 in accordance with some other embodiments of the present disclosure. As shown in FIG. 2B, in accordance with some embodiments, the bridge structure 204B may further include one or more dummy dies DM positioned in the second layer 204B-b and adjacent to the second bridge unit BU2. The dielectric material 204i may surround the dummy die DM. The dummy die DM can provide additional structural support for the bridge structure 204B, especially when the dimensional difference between the first bridge unit BU1 and the second bridge unit BU2 is large. In accordance with some embodiments, the dummy die DM may be formed of semiconductor materials, such as silicon (Si) or silicon carbide (SiC).

In accordance with some embodiments, the dummy die DM has a dimension smaller than that of the first bridge unit BU1. The dummy die DM has a width Wd and a height Hd. In accordance with some embodiments, the width W1 of the first bridge unit BU1 is greater than width Wd of the dummy die DM. In accordance with some embodiments, the height H1 of the first bridge unit BU1 is greater than the height Hd of the dummy die DM. In accordance with some embodiments, the height Hd of the dummy die DM is substantially the same as the height H2 of the second bridge unit BU2. The width Wd may refer to the maximum width of the dummy die DM along a direction perpendicular to the normal direction of the substrate 102. The height Hd may refer to the maximum height of the dummy die DM along the normal direction of the substrate 102.

It should be noted that the number of dummy die DM and conductive vias 204v shown in figures is an example and the present disclosure is not limited thereto.

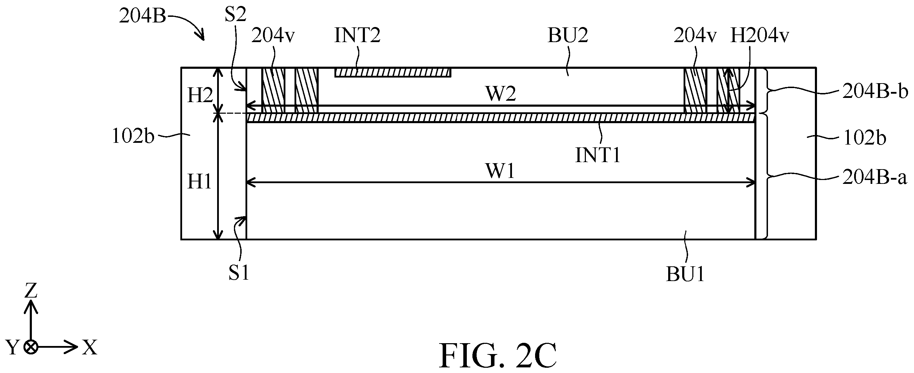

Referring to FIG. 2C, which is an enlarged diagram of area R1 in FIG. 1 including the bridge structure 204B of the exemplary semiconductor package structure 10 in accordance with some other embodiments of the present disclosure. As shown in FIG. 2C, in accordance with some embodiments, the second layer 204B-b of the bridge structure 204B does not include the dielectric material 204i. The conductive via 204v may penetrate the second bridge unit BU2. In other words, in this embodiment, the conductive via 204v may be a through-silicon-via. Moreover, in this embodiment, the width W1 of the first bridge unit BU1 is substantially the same as the width W2 of the second bridge unit BU2. In this embodiment, the side surface S1 of the first bridge unit BU1 may be aligned with the side surface S2 of the second bridge unit BU2. The side surface S1 of the first bridge unit BU1 may be coplanar with the side surface S2 of the second bridge unit BU2.

In this embodiment, the first bridge unit BU1 and the second bridge unit BU2 may be bonded together through a wafer-on-wafer process, and then a singulation process may be performed to separate the bonded structure into individual units. In accordance with some embodiments, the wafer-on-wafer process may include a hybrid bonding process. Specifically, the wafer-on-wafer process may include a hybrid bonding process in which two processed wafers are aligned and bonded at the wafer level. The bonding interface may include dielectric-to-dielectric bonding and metal-to-metal bonding between corresponding bonding pads or interconnect features formed on the respective wafers. In accordance with some embodiments, the singulation process may include forming a plurality of cutting lanes on the wafer surface, followed by removing material along the cutting lanes using a mechanical saw, a laser dicing process, a plasma dicing process, or a combination thereof. The conductive vias 204v then may be formed to penetrate second bridge unit BU2. Thereafter, the multi-layer bridge structure 204B may be embedded in the dielectric layer 102b of the redistribution layer RD-1 (as shown in FIG. 1).

Please refer to FIG. 1 again, in accordance with some embodiments, the semiconductor package structure 10 may further include an underfill 209 filling the gaps between the semiconductor dies 300 and the substrate 102, and the gaps between the memory components 400 and the substrate 102. In accordance with some embodiments, the underfill 209 may surround the conductive connectors 208. In addition, the underfill 209 may be disposed to compensate for differing coefficients of thermal expansion (CTEs) between the semiconductor dies 300, memory components 400, the conductive connectors 208 and the substrate 102. In accordance with some embodiments, the underfill 209 may be formed of polymer, such as epoxy or another suitable material.

As shown in FIG. 1, the semiconductor package structure 10 may further include a metal layer 502 disposed over the semiconductor dies 300 and the memory components 400. The metal layer 502 may be in contact with the top surfaces of the semiconductor dies 300 and the memory components 400. The metal layer 502 may be continuously disposed over multiple semiconductor dies 300 and memory components 400. In accordance with some other embodiments, the metal layer 502 may be discontinuously disposed over multiple semiconductor dies 300 and memory components 400. For example, the metal layer 502 may include separate portions disposed over the semiconductor dies 300 and the memory components 400 respectively.

The metal layer 502 can improve thermal conduction, protect the underlying structures, or enhance the mechanical reliability of the semiconductor package structure. In accordance with some embodiments, the metal layer 502 may be formed of titanium (Ti), nickel (Ni), gold (Au), aluminum (Al), copper (Cu), vanadium (V), tungsten (W), titanium nitride (TiN), titanium tungsten (TiW), molybdenum (Mo), the like, or a combination thereof. In accordance with some embodiments, the metal layer 502 may include a multi-layer stack.

As shown in FIG. 1, the semiconductor package structure 10 may further include a thermal dissipation layer 504 is disposed over the metal layer 502. The thermal dissipation layer 504 may be in contact with the metal layer 502 to enhance its thermal conductivity. The thermal dissipation layer 504 may be conformally disposed on the metal layer 502. The thermal dissipation layer 504 may be continuously disposed over the metal layer 502. In accordance with some other embodiments, the thermal dissipation layer 504 may be discontinuously disposed over the metal layer 502. For example, the thermal dissipation layer 504 may include separate portions disposed over the metal layer 502.

The thermal dissipation layer 504 may include a thermal interface material (TIM). The thermal dissipation layer 504 can fill interfacial gaps between the metal layer 502 and a lid 506, thereby reducing interfacial thermal resistance. In accordance with some embodiments, the thermal dissipation layer 504 may include metallic materials such as indium (In), indium-tin (In-Sn) alloys, indium-silver (In-Ag) alloys, copper (Cu), the like, or a combination thereof. In accordance with some embodiments, the thermal dissipation layer 504 may further include polymer-based materials containing thermally conductive fillers, such as alumina (Al₂O₃), boron nitride (BN), or aluminum nitride (AlN), but it is not limited thereto.

As shown in FIG. 1, the semiconductor package structure 10 may further include a lid 506 and a ring member 510 mounted on the substrate 102. The lid 506 may be disposed over and in contact with the thermal dissipation layer 504. The thermal dissipation layer 504 may be disposed between the lid 506 and the metal layer 502 to provide a thermally conductive path. In accordance with some embodiments, the lid 506 is mechanically supported and fixed by the ring member 510. In accordance with some embodiments, an adhesive layer (not shown) may be used to bond the lid 506 to the ring member 510 or the substrate 102. In accordance with some embodiments, the lid 506 may be made by a metal material, such as copper, aluminum, iron or a combination thereof. In accordance with some embodiments, the lid 506 may be made by a non-metal material, such as a ceramic material, a polymer material or another applicable non-metal material.

The ring member 510 may be fixed on the substrate 102 opposite the conductive structures 110 using an adhesive layer (not shown). The ring member 510 may be adhered onto the substrate 102 along edges of the substrate 102. The ring member 510 may laterally surround the semiconductor dies 300, memory components 400, the conductive connectors 208, and the underfill 209. In accordance with some embodiments, the ring member 510 may also laterally surround the metal layer 502, the thermal dissipation layer 504, and the lid 506. In accordance with some embodiments, the top surface 510T of the ring member 510 is aligned with the top surface 506T of the lid 506. The ring member 510 may include a stiffener ring. In accordance with some embodiments, the ring member 510 is used for warpage control to reduce the high stress experienced by bonded various materials in the semiconductor package structure during cycles of heating and cooling. The ring member 510 may provide extra support to the semiconductor package structure 10 thus reducing warpage, preventing bending, and maintaining planarity of the substrate 102. In accordance with some embodiments, edges of the ring member 510 are leveled with the corresponding edges of the substrate 102. Therefore, the edges of the ring member 510 and the edges of the substrate 102 may collectively serve as edges of the semiconductor package structure 10. In accordance with some embodiments, the ring member 510 includes molding compound, epoxy, metal (e.g., copper), another suitable material, or a combination thereof, but it is not limited thereto.

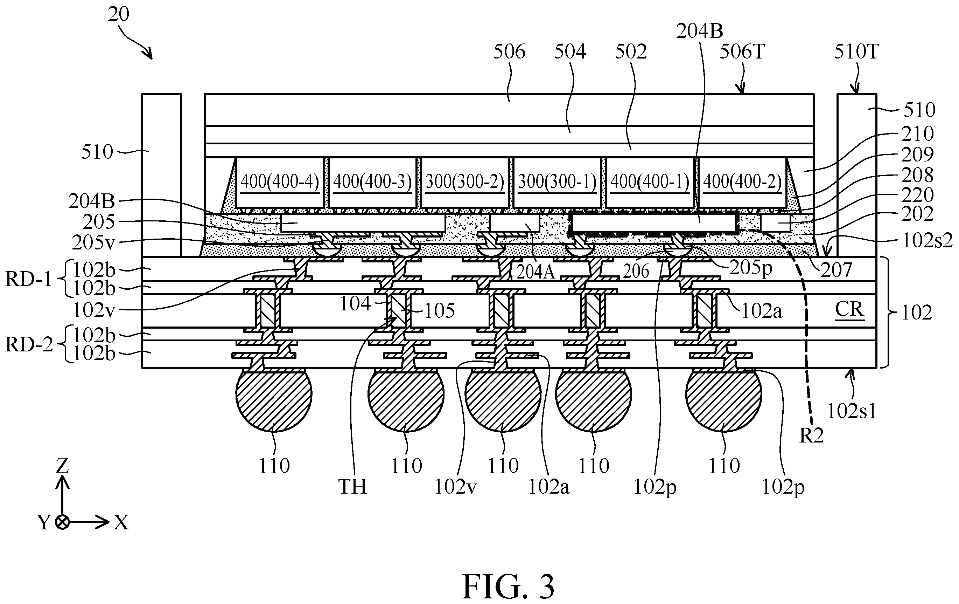

Next, please refer to FIG. 3, which is a cross-sectional diagram of an exemplary semiconductor package structure 20 in accordance with some other embodiments of the present disclosure. It should be understood that some elements of the semiconductor package structure 20 may be omitted in the figure for clarity, and only some elements are schematically illustrated. In accordance with some embodiments, additional features may be added to the semiconductor package structure 20 described below. In accordance with some other embodiments, some features of the semiconductor package structure 20 described below may be replaced or omitted. Moreover, the same or similar components or elements in above and below contexts are represented by the same or similar reference numerals. The materials, manufacturing methods and functions of these components or elements are the same or similar to those described above, and thus will not be repeated in the following description.

Compared with the semiconductor package structure 10, the semiconductor package structure 20 further includes an interposer 202, and the bridge structure 204B is embedded in the interposer 202. Specifically, as shown in FIG. 3, the semiconductor package structure 20 may include a substrate 102, an interposer 202, a bridge structure 204A, a bridge structure 204B, a semiconductor die 300 (including semiconductor dies 300-1 and 300-2), and a memory component 400 (including memory components 400-1, 400-2, 400-3 and 400-4).

As shown in FIG. 3, the interposer 202 is disposed over the substrate 102. The interposer 202 is disposed between the substrate 102 and the semiconductor dies 300, and between the substrate 102 and the memory components 400. In this embodiment, the bridge structures 204A and 204B are embedded in the interposer 202. The bridge structures 204A and 204B may be embedded in the upper portion of the interposer 202. The bridge structures 204A and 204B may be disposed in recesses (not shown) formed in the upper portion of the interposer 202. The bridge structure 204A may vertically overlap the semiconductor dies 300. The bridge structure 204B may vertically overlap the semiconductor die 300 and the memory components 400. For example, the bridge structure 204B may vertically overlap the semiconductor die 300-1, the memory component 400-1 and the memory component 400-2. The bridge structure 204B may vertically overlap the semiconductor die 300-2, the memory component 400-3 and the memory component 400-4.

The interposer 202 may further include a redistribution structure (not shown) embedded therein. For example, the interposer 202 may further include one or more conductive traces 205, one or more conductive vias 205v disposed in one or more dielectric layers (not shown), and conductive pads 205p. The conductive traces 205 are coupled to the corresponding conductive pads 205p. The conductive pads 205p are exposed to openings of the solder mask layer (not shown) and close to the substrate 102. The conductive connectors 206 are disposed on and in contact with the corresponding conductive pads 205p.

In accordance with some embodiments, the material of the conductive traces 205, the conductive vias 205v, and the conductive pads 205p of the interposer 202 may be similar to the material of the conductive layers 102a, the conductive vias 102v, and the conductive pads 102p of the substrate 102. In addition, the material of the dielectric layers (not shown) of the interposer 202 may be similar to the material of the dielectric layers 102b. In accordance with some embodiments, the interposer 202 may be formed of organic polymer, including polyimide (PI), polybenzoxazole (PBO), benzocyclobutene (BCB), epoxy, Ajinomoto build-up film (ABF), Bismaleimide-Triazine (BT resin), another suitable organic dielectric material, or a combination thereof, but it is not limited thereto.

It should be noted that in the interposer 202, the number of conductive traces 205, the number of conductive vias 205v, and the number of conductive pads 205p shown in FIG. 3 are an example and the present disclosure is not limited thereto.

The conductive connectors 206 are disposed between the substrate 102 and the interposer 202. The interposer 202 is coupled to the substrate 102 through the conductive connectors 206. Specifically, the conductive connectors 206 are coupled between the conductive pads 205p and the conductive pads 102p of the substrate 102. In accordance with some embodiments, the conductive connectors 206 may include a conductive ball structure such as a copper ball, a conductive bump structure such as a copper bump or a solder bump structure, or a conductive pillar structure such as a copper pillar structure. For example, the conductive connectors 206 may be controlled collapse chip connection (C4) structures.

In accordance with some embodiments, the semiconductor package structure 20 further includes an underfill 207. As shown in FIG. 3, the underfill 207 may fill the gap between the interposer 202 and the substrate 102. In accordance with some embodiments, the underfill 207 may surround a lower portion of the interposer 202 and the conductive connectors 206, and is in contact with a portion of the substrate 102 to further reduce the thermal resistance from the interposer 202 to the substrate 102. In addition, the underfill 207 may be disposed to compensate for differing coefficients of thermal expansion (CTEs) between the interposer 202, the conductive connectors 206 and the substrate 102. In accordance with some embodiments, the underfill 207 may be formed of a molding compound material such as an epoxy molding compound. In accordance with some embodiments, the underfill 207 may further include inorganic fillers such as silica, alumina, silicon nitride, aluminum nitride, or boron nitride.

As shown in FIG. 3, the semiconductor package structure 20 may further include a passive component 220 disposed in the interposer 202. one or more passive components 220 disposed within the interposer 202. The passive components may be embedded in the interposer 202. The passive component 220 may be coupled to the redistribution structure of the interposer 202. The passive component 220 may be an integrated passive device. In accordance with some embodiments, the passive component may include a resistor, a capacitor, an inductor, or another suitable passive component.

As shown in FIG. 3, the bridge structure 204A may be coupled between the semiconductor dies 300-1 and 300-2. The bridge structure 204B may be coupled between the semiconductor die 300 and two memory components 400. In particular, the bridge structure 204B may be coupled between the semiconductor die 300-1 and the memory component 400-1, and between the semiconductor die 300-1 and the memory component 400-2. Moreover, the bridge structures 204A and 204B may be coupled to the redistribution structure embedded in the interposer 202 (e.g., the conductive traces 205, conductive vias 205v and conductive pads 205p).

Moreover, the semiconductor dies 300 (including semiconductor dies 300-1 and 300-2) are disposed over the interposer 202 and overlap the bridge structure 204B. The semiconductor dies 300 may be mounted on the interposer 202 by a bonding process using conductive connectors 208. The memory components 400 are disposed over the interposer 202 and overlap the bridge structure 204B, where a molding material 210 may surround semiconductor dies 300, the memory components 400, the underfill 209 and the conductive connectors 208. Specifically, the memory component 400-1 and the memory component 400-2 overlap the bridge structure 204B. The memory component 400-1 is adjacent to the semiconductor die 300-1, and the memory component 400-2 is adjacent to the memory component 400-1. Similarly, the memory component 400-3 and the memory component 400-4 overlap the bridge structure 204B. The memory component 400-3 is adjacent to the semiconductor die 300-2, and the memory component 400-4 is adjacent to the memory component 400-3. The semiconductor die 300-1 may be respectively coupled to the memory components 400-1 and 400-2 through the bridge structure 204B. The semiconductor die 300-2 may be respectively coupled to the memory components 400-3 and 400-4 through the bridge structure 204B.

It should be noted that the number of bridge structures 204A and 204B, the number of semiconductor dies 300, the number of memory components 400 of the semiconductor package structure 20 shown in FIG. 3 are an example and the present disclosure is not limited thereto.

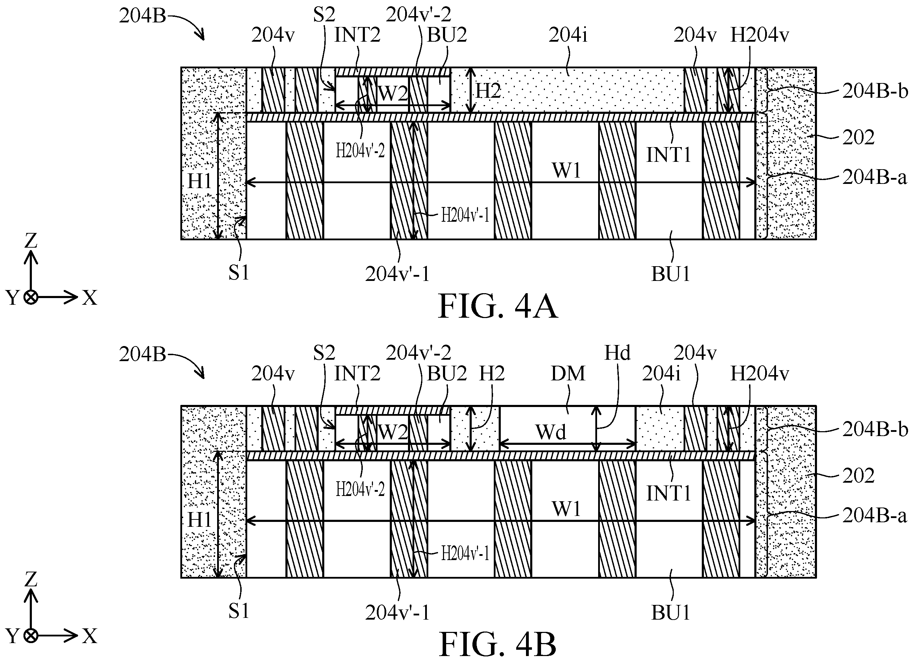

Refer to FIG. 4A, which is an enlarged diagram of area R2 in FIG. 3 including the bridge structure 204B of the exemplary semiconductor package structure 20 in accordance with some embodiments of the present disclosure. The bridge structure 204B may be a multi-layer bridge structure. The bridge structure 204B is embedded in the interposer 202. As shown in FIG. 4A, the bridge structure 204B includes a first bridge unit BU1 and a second bridge unit BU2 disposed over the first bridge unit BU1. The first bridge unit BU1 and the second bridge unit BU2 each may be a bridge die. Specifically, the bridge structure 204B has a first layer 204B-a and a second layer 204B-b disposed over the first layer 204B-a, the first bridge unit BU1 is positioned in the first layer 204B-a, and the second bridge unit BU2 is positioned in the second layer 204B-b. The second bridge unit BU2 overlaps the first bridge unit BU1 in the normal direction of the of the substrate 102. The first bridge unit BU1 may vertically overlap the semiconductor die 300-1, the memory component 400-1, and the memory component 400-2. The second bridge unit BU2 may vertically overlap the semiconductor die 300-1, the memory component 400-1, and the memory component 400-2. The second bridge unit BU2 may vertically overlap the semiconductor die 300-1 and the memory component 400-1, but not the memory component 400-2.

In this embodiment, the first bridge unit BU1 has a dimension greater than that of the second bridge unit BU2. The width W1 of the first bridge unit BU1 may be greater than width W2 of the second bridge unit BU2. The height H1 of the first bridge unit BU1 may be greater than height H2 of the second bridge unit BU2. Moreover, the side surface S1 of the first bridge unit BU1 may protrude outward relative to the side surface S2 of the second bridge unit BU2. The first bridge unit BU1 includes an interconnect structure INT1. The second bridge unit BU2 includes an interconnect structure INT2.

As shown in FIG. 4A, the bridge structure 204B further includes one or more conductive vias 204v positioned in the second layer 204B-b, and the semiconductor die 300-1 is coupled to the first bridge unit BU1 through the conductive via 204v. The bridge structure 204B further includes a dielectric material 204i surrounding the second bridge unit BU2, and the conductive via 204v penetrates the dielectric material 204i. Moreover, the height H204v of the conductive via 204v may be substantially the same as the height H2 of the second bridge unit BU2. In this embodiment, the bridge structure 204B further includes one or more conductive vias 204v'-1 penetrating the first bridge unit BU1 and one or more second conductive vias 204v'-2 penetrating the second bridge unit BU2. In other words, the conductive vias 204v'-1 and 204v'-2 may be through-silicon-vias. The conductive vias 204v'-1 and 204v'-2 may provide vertical electrical interconnections between the interconnect structures INT1 and INT2, facilitate high-bandwidth signal transmission, or further contribute to thermal conduction and mechanical reinforcement within the interposer 202. Moreover, the height H204v'-1 of the conductive via 204v'-1 may be substantially the same as the height H1 of the first bridge unit BU1. The height H204v'-2 of the conductive via 204v'-2 may be substantially the same as the height H2 of the second bridge unit BU2.

The semiconductor die 300 may be respectively coupled to more than one memory components 400 through different bridge units positioned in the first layer 204B-a and the second layer 204B-b. The semiconductor die 300-1 may be coupled to the memory component 400-1 through the second bridge unit BU2, and the semiconductor die 300-1 may be coupled to the memory component 400-2 through the first bridge unit BU1. Specifically, the semiconductor die 300-1 may be coupled to the memory component 400-1 through the interconnect structure INT2 and the conductive vias 204v'-2 of the second bridge unit BU2. The semiconductor die 300-1 may be coupled to the memory component 400-2 through the conductive vias 204v and the interconnect structure INT1 and the conductive vias 204v'-1 of the first bridge unit BU1.

In this embodiment, the first bridge unit BU1 and the second bridge unit BU2 may be bonded together through a chip-on-wafer process, and then a singulation process may be performed to separate the bonded structure into individual units. In addition, the conductive vias 204v'-1 may be formed in the first bridge unit BU1, and the conductive vias 204v'-2 may be formed in the second bridge unit BU2 before the bonding of the first bridge unit BU1 and the second bridge unit BU2. The chip-on-wafer process may include a hybrid bonding process. The singulation process may include forming a plurality of cutting lanes on the wafer surface, followed by removing material along the cutting lanes using a mechanical saw, a laser dicing process, a plasma dicing process, or a combination thereof. The dielectric material 204i then may be formed over the first bridge unit BU1 and surrounding the second bridge unit BU2. The conductive vias 204v then may be formed to penetrate the dielectric material 204i. Thereafter, the multi-layer bridge structure 204B may be embedded in the interposer 202 (as shown in FIG. 3).

It should be noted that the number of conductive vias 204v, conductive vias 204v'-1, and conductive vias 204v'-2 shown in figures is an example and the present disclosure is not limited thereto.

Referring to FIG. 4B, which is an enlarged diagram of area R2 in FIG. 3 including the bridge structure 204B of the exemplary semiconductor package structure 20 in accordance with some other embodiments of the present disclosure. As shown in FIG. 4B, the bridge structure 204B may further include one or more dummy dies DM positioned in the second layer 204B-b and adjacent to the second bridge unit BU2. The dielectric material 204i may surround the dummy die DM. The dummy die DM can provide additional structural support for the bridge structure 204B, especially when the dimensional difference between the first bridge unit BU1 and the second bridge unit BU2 is large.

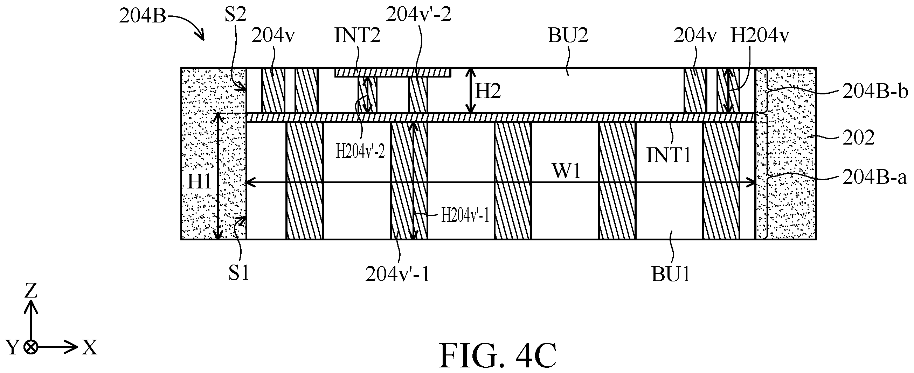

Referring to FIG. 4C, which is an enlarged diagram of area R2 in FIG. 3 including the bridge structure 204B of the exemplary semiconductor package structure 20 in accordance with some other embodiments of the present disclosure. As shown in FIG. 4C, in this embodiment, the second layer 204B-b of the bridge structure 204B does not include the dielectric material 204i. The conductive via 204v may penetrate the second bridge unit BU2. The conductive via 204v may be a through-silicon-via. In this embodiment, the width W1 of the first bridge unit BU1 is substantially the same as the width W2 of the second bridge unit BU2. In this embodiment, the side surface S1 of the first bridge unit BU1 may be aligned with the side surface S2 of the second bridge unit BU2. The side surface S1 of the first bridge unit BU1 may be coplanar with the side surface S2 of the second bridge unit BU2.

In this embodiment, the first bridge unit BU1 and the second bridge unit BU2 may be bonded together through a wafer-on-wafer process, and then a singulation process may be performed to separate the bonded structure into individual units. In addition, the conductive vias 204v'-1 may be formed in the first bridge unit BU1, and the conductive vias 204v'-2 may be formed in the second bridge unit BU2 before the bonding of the first bridge unit BU1 and the second bridge unit BU2. The wafer-on-wafer process may include a hybrid bonding process. The singulation process may include forming a plurality of cutting lanes on the wafer surface, followed by removing material along the cutting lanes using a mechanical saw, a laser dicing process, a plasma dicing process, or a combination thereof. The conductive vias 204v then may be formed to penetrate second bridge unit BU2. Thereafter, the multi-layer bridge structure 204B may be embedded in the interposer 202 (as shown in FIG. 3).

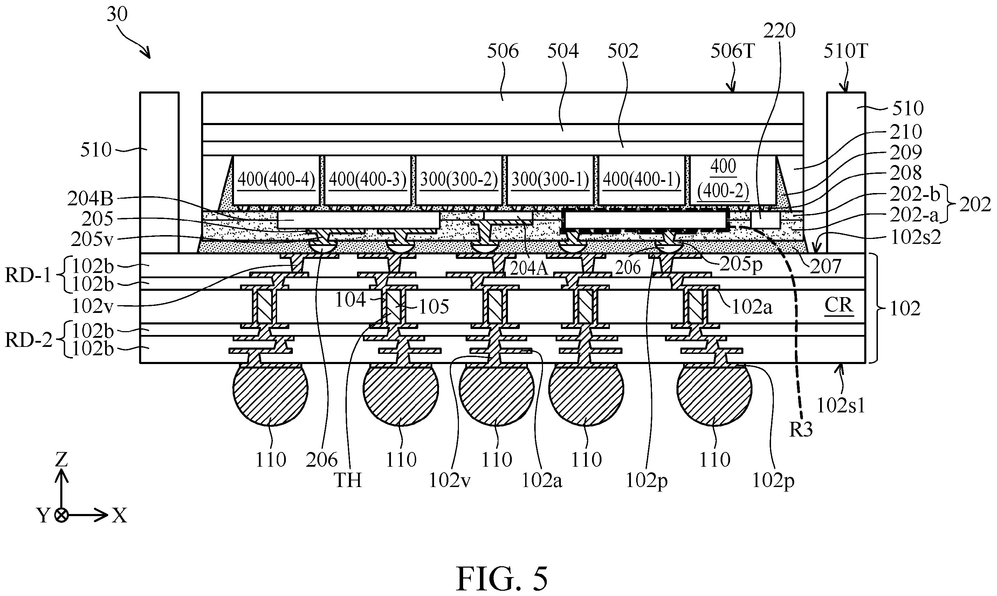

Next, please refer to FIG. 5, which is a cross-sectional diagram of an exemplary semiconductor package structure 30 in accordance with some other embodiments of the present disclosure. It should be understood that some elements of the semiconductor package structure 30 may be omitted in the figure for clarity, and only some elements are schematically illustrated. In accordance with some embodiments, additional features may be added to the semiconductor package structure 30 described below. In accordance with some other embodiments, some features of the semiconductor package structure 30 described below may be replaced or omitted.

Compared with the semiconductor package structure 20, the interposer 202 of the semiconductor package structure 30 has a multi-layer structure. The interposer 202 has a first layer 202-a and a second layer 202-b disposed over the first layer 202-a. Specifically, as shown in FIG. 5, the semiconductor package structure 30 may include a substrate 102, an interposer 202, a bridge structure 204A, a bridge structure 204B, a semiconductor die 300 (including semiconductor dies 300-1 and 300-2), and a memory component 400 (including memory components 400-1, 400-2, 400-3 and 400-4).

As shown in FIG. 5, the interposer 202 is disposed over the substrate 102. The interposer 202 is disposed between the substrate 102 and the semiconductor dies 300, and between the substrate 102 and the memory components 400. In this embodiment, the bridge structures 204A and 204B are embedded in the interposer 202. The bridge structure 204A and the bridge structure 204B may be disposed in different layers of the multi-layer interposer 202. For example, the bridge structure 204A may be disposed in the second layer 202-b and the bridge structure 204B may be disposed in the first layer 202-a. Moreover, the first layer 202-a and the second layer 202-b may be formed of the same or different materials.

As shown in FIG.5, the bridge structure 204A may be coupled between the semiconductor dies 300-1 and 300-2. The bridge structure 204B may be coupled between the semiconductor die 300-1 and the memory component 400-1, and between the semiconductor die 300-1 and the memory component 400-2. Moreover, the bridge structures 204A and 204B may be coupled to the redistribution structure embedded in the interposer 202. The semiconductor die 300-1 and the semiconductor die 300-2 overlap the bridge structure 204A. Moreover, the semiconductor dies 300 are disposed over the interposer 202 and overlap the bridge structure 204B. The memory components 400 are disposed over the interposer 202 and overlap the bridge structure 204B. Specifically, the memory component 400-1 and the memory component 400-2 overlap the bridge structure 204B. The memory component 400-1 is adjacent to the semiconductor die 300-1, and the memory component 400-2 is adjacent to the memory component 400-1. Similarly, the memory component 400-3 and the memory component 400-4 overlap the bridge structure 204B. The memory component 400-3 is adjacent to the semiconductor die 300-2, and the memory component 400-4 is adjacent to the memory component 400-3. The semiconductor die 300-1 may be respectively coupled to the memory components 400-1 and 400-2 through the bridge structure 204B. The semiconductor die 300-2 may be respectively coupled to the memory components 400-3 and 400-4 through the bridge structure 204B.

It should be noted that the number of bridge structures 204A and 204B, the number of semiconductor dies 300, the number of memory components 400 of the semiconductor package structure 30 shown in FIG. 5 are an example and the present disclosure is not limited thereto.

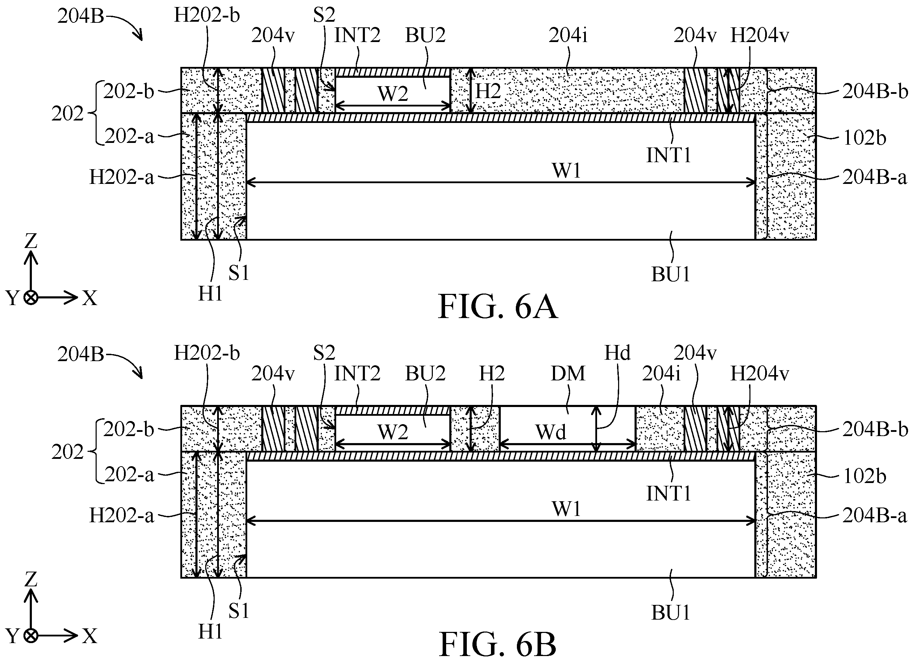

Refer to FIG. 6A, which is an enlarged diagram of area R3 in FIG. 5 including the bridge structure 204B of the exemplary semiconductor package structure 30 in accordance with some embodiments of the present disclosure. The bridge structure 204B may be a multi-layer bridge structure. The bridge structure 204B is embedded in the first layer 202-a and the second layer 202-b of the interposer 202. As shown in FIG. 6A, the bridge structure 204B includes a first bridge unit BU1 and a second bridge unit BU2 disposed over the first bridge unit BU1. The first bridge unit BU1 and the second bridge unit BU2 each may be a bridge die. Specifically, the bridge structure 204B has a first layer 204B-a and a second layer 204B-b disposed over the first layer 204B-a, the first bridge unit BU1 is positioned in the first layer 204B-a, and the second bridge unit BU2 is positioned in the second layer 204B-b. More specifically, in this embodiment, the first bridge unit BU1 and the second bridge unit BU2 are respectively disposed in the first layer 202-a and the second layer 202-b of the interposer 202. The second bridge unit BU2 overlaps the first bridge unit BU1 in the normal direction of the of the substrate 102. The first bridge unit BU1 may vertically overlap the semiconductor die 300-1, the memory component 400-1, and the memory component 400-2. The second bridge unit BU2 may vertically overlap the semiconductor die 300-1, the memory component 400-1, and the memory component 400-2. The second bridge unit BU2 may vertically overlap the semiconductor die 300-1 and the memory component 400-1, but not the memory component 400-2.

In this embodiment, the first bridge unit BU1 has a dimension greater than that of the second bridge unit BU2. The width W1 of the first bridge unit BU1 may be greater than width W2 of the second bridge unit BU2. The height H1 of the first bridge unit BU1 may be greater than height H2 of the second bridge unit BU2. Moreover, the side surface S1 of the first bridge unit BU1 may protrude outward relative to the side surface S2 of the second bridge unit BU2. The first bridge unit BU1 includes an interconnect structure INT1. The second bridge unit BU2 includes an interconnect structure INT2.

As shown in FIG. 6A, the bridge structure 204B further includes one or more conductive vias 204v positioned in the second layer 202-b of the interposer 202, and the semiconductor die 300-1 is coupled to the first bridge unit BU1 through the conductive via 204v. The conductive via 204v penetrates the second layer 202-b of the interposer 202. In this embodiment, the conductive via 204v may be a through-interposer-via. The height H204v of the conductive via 204v may be substantially the same as the height H2 of the second bridge unit BU2. In this embodiment, the first layer 202-a of the interposer 202 has a height H202-a, and the second layer 202-b has a height H202-b. The height H1 of the first bridge unit BU1 may be substantially the same as the height H202-a of the first layer 202-a. The height H2 of the second bridge unit BU2 may be substantially the same as the height H202-b of the second layer 202-b. Furthermore, the height H204v of the conductive via 204v may be substantially the same as the height H202-b of the second layer 202-b. The height H202-a may refer to the maximum height of the first layer 202-a of the interposer 202 along the normal direction of the substrate 102. The height H202-b may refer to the maximum height of the second layer 202-b of the interposer 202 along the normal direction of the substrate 102.

The semiconductor die 300 may be respectively coupled to more than one memory components 400 through different bridge units positioned in the first layer 202-a and the second layer 202-b. The semiconductor die 300-1 may be coupled to the memory component 400-1 through the second bridge unit BU2, and the semiconductor die 300-1 may be coupled to the memory component 400-2 through the first bridge unit BU1. Specifically, the semiconductor die 300-1 may be coupled to the memory component 400-1 through the interconnect structure INT2 of the second bridge unit BU2. The semiconductor die 300-1 may be coupled to the memory component 400-2 through the conductive vias 204v and the interconnect structure INT1 of the first bridge unit BU1.

Referring to FIG. 6B, which is an enlarged diagram of area R3 in FIG. 5 including the bridge structure 204B of the exemplary semiconductor package structure 30 in accordance with some other embodiments of the present disclosure. As shown in FIG. 6B, the bridge structure 204B may further include one or more dummy dies DM positioned in the second layer 202-b and adjacent to the second bridge unit BU2. The dielectric material 204i may surround the dummy die DM. The dummy die DM can provide additional structural support for the bridge structure 204B, especially when the dimensional difference between the first bridge unit BU1 and the second bridge unit BU2 is large.

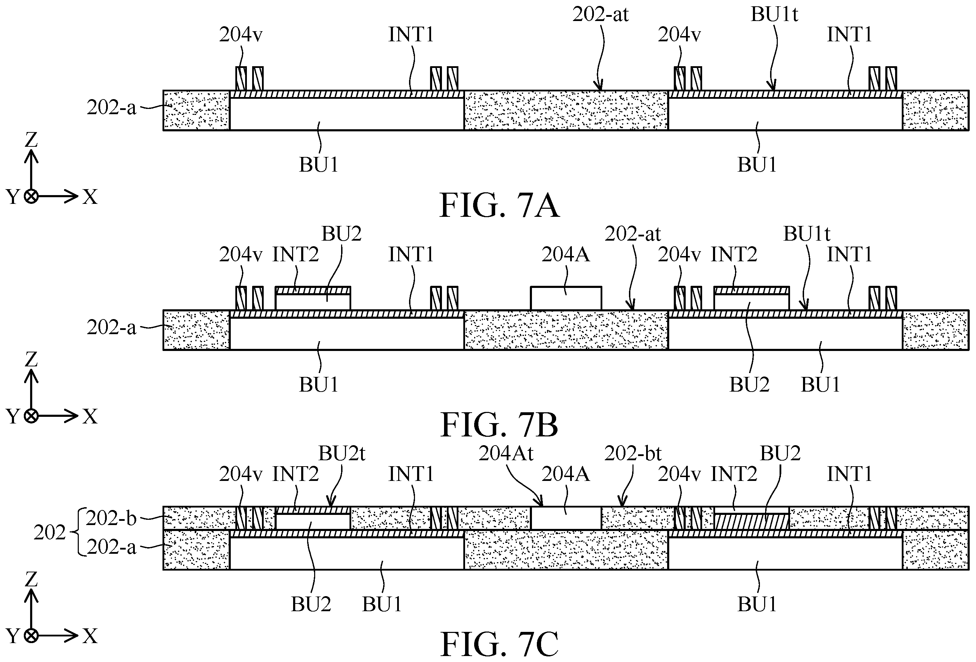

Refer to FIGs. 7A to 7D, which are cross-sectional diagrams of an exemplary semiconductor package structure (for example, similar to semiconductor package structure 30) during the manufacturing processes in accordance with some embodiments of the present disclosure. It should be understood that, additional operations may be provided before, during, or after the processes for manufacturing the semiconductor package structure. In accordance with some embodiments, some of the operations described below may be replaced or eliminated. In accordance with some embodiments, the order of the operations may be interchangeable.

Referring to FIG. 7A, the first layer 202-a of the interposer 202 is provided, and the first bridge unit BU1 is formed in the first layer 202-a of the interposer 202. The first bridge unit BU1 includes the interconnect structure INT1. The first layer 202-a may be formed by a spin coating process, a chemical vapor deposition (CVD) process, a lamination process, or another applicable process. Moreover, one or more photolithography processes and/or etching processes may be used to formed the first layer 202-a.

In accordance with some embodiment, the top surface BU1t of the first bridge unit BU1 is aligned with the top surface 202-at of the first layer 202-a. The top surface BU1t of the first bridge unit BU1 may be coplanar with the top surface 202-at of the first layer 202-a. In accordance with some embodiments, a planarization process may be performed on the top surface 202-at of the first layer 202-a and the top surface BU1t of the first bridge unit BU1. The planarization process may include a grinding process, a chemical-mechanical polish (CMP) process, another suitable planarization process, or another applicable process.

The conductive vias 204v then may be formed over the first bridge unit BU1. The conductive vias 204v are coupled to the interconnect structure INT1 of the first bridge unit BU1. In accordance with some embodiments, the conductive via 204v may be formed by a physical vapor deposition (PVD) process, an electroplating process, an electroless plating process, or another applicable process. Moreover, one or more photolithography processes and/or etching processes may be used to formed the conductive via 204v.

Referring to FIG. 7B, the second bridge unit BU2 is formed over first bridge unit BU1 and the first layer 202-a of the interposer 202. The conductive vias 204v may surround the second bridge unit BU2. Moreover, the bridge structure 204A is formed over the first layer 202-a of the interposer 202. The second bridge unit BU2 may be formed over the first bridge unit BU1 through a hybrid bonding process.

Referring to FIG. 7C, the second layer 202-b then is formed over the first layer 202-a and covering the first bridge unit BU1. The second layer 202-b may fill the space between the conductive vias 204v, between the second bridge unit BU2 and the conductive via 204v, and between the bridge structure 204A and the conductive via 204v. The second layer 202-b may be formed by a spin coating process, a chemical vapor deposition (CVD) process, a lamination process, or another applicable process. Moreover, one or more photolithography processes and/or etching processes may be used to formed the second layer 202-b.

In accordance with some embodiment, the top surface BU2t of the second bridge unit BU2 is aligned with the top surface 202-bt of the second layer 202-b. The top surface BU2t of the second bridge unit BU2 may be coplanar with the top surface 202-bt of the second layer 202-b. Moreover, in accordance with some embodiment, the top surface 204At of the bridge structure 204A is aligned with the top surface 202-bt of the second layer 202-b. The top surface 204At of the bridge structure 204A may be coplanar with the top surface 202-bt of the second layer 202-b. In accordance with some embodiments, a planarization process may be performed on the top surface 202-bt of the second layer 202-b, the top surface BU2t of the second bridge unit BU2, and the top surface 204At of the bridge structure 204A. The planarization process may include a grinding process, a chemical-mechanical polish (CMP) process, another suitable planarization process, or another applicable process.

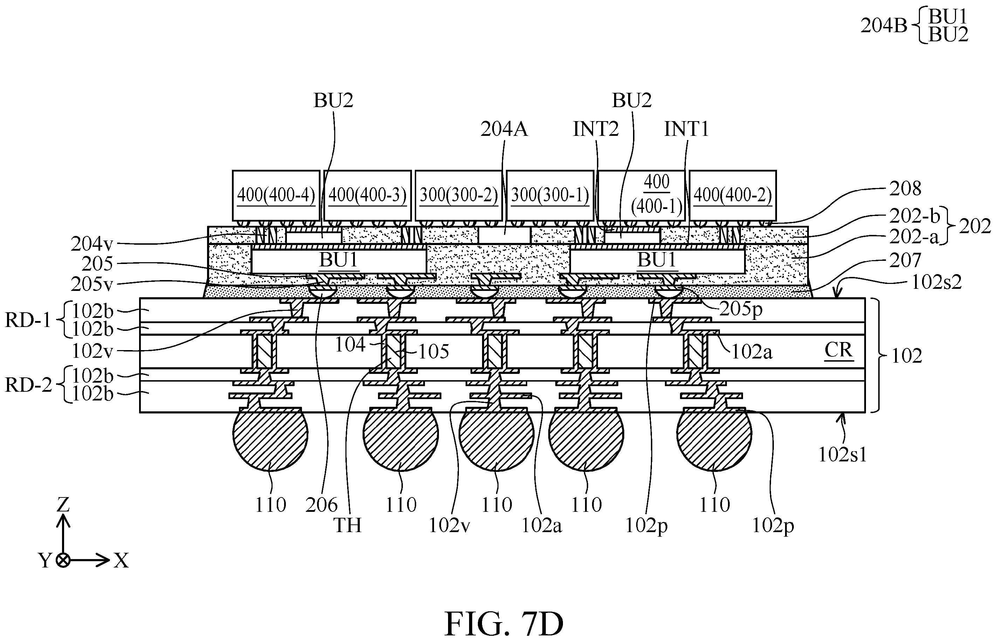

Referring to FIG. 7D, the semiconductor dies 300 and the memory components 400 are mounted on the multi-layer interposer 202 by a bonding process using conductive connectors 208. In accordance with some embodiments, the conductive connectors 208 may be formed by a reflow process, or another suitable process. In accordance with some embodiments, the redistribution structure (e.g., the conductive traces 205, conductive vias 205v and conductive pads 205p) may be formed in the interposer 202 before the semiconductor dies 300 and the memory components 400 are mounted.

The aforementioned structure then is mounted on the top surface 102s2 of the substrate 102 through the conductive connectors 206. In accordance with some embodiments, the conductive connectors 206 may be formed by a reflow process, or another suitable process. In addition, the underfill 207 may be formed to fill the gap between the interposer 202 and the substrate 102. In accordance with some embodiments, the underfill 207 may be dispensed with capillary force, and then may be cured through any suitable curing process.

Thereafter, the conductive structures 110 may be formed on the bottom surface 102s1 of the substrate 102. The conductive structures 110 may be mounted directly on the conductive pads 102p. In accordance with some embodiments, the conductive structures 110 may be formed by a reflow process, or another suitable process.

The metal layer 502, the thermal dissipation layer 504, and the lid 506 then may be formed over the semiconductor dies 300 and the memory components 400. In addition, the ring member 510 may be fixed on the top surface 102s2 of the substrate 102 using an adhesive layer. Thereafter, the semiconductor package structure 30 as shown in FIG. 5 can be obtained.

To summarize the above, the embodiments of the present disclosure provide a semiconductor package structure that utilizes an embedded, multi-layer interconnect configuration (e.g., a multi-layer bridge structure), which can increase the number of memory components that can be electrically connected to a logic die. By enabling additional routing channels, the semiconductor package structure accommodates a greater quantity of memory components, which can be used to support higher-capacity and/or higher bandwidth performance, which can be advantageous for high-performance computing, artificial intelligence acceleration, and other bandwidth-intensive applications. Accordingly, the performance of the semiconductor package structure is enhanced.

Embodiments provide a semiconductor package structure. The semiconductor package structure includes a substrate, a bridge structure, a first semiconductor die, a first memory component, and a second memory component. The bridge structure is embedded in the substrate. The bridge structure includes a first bridge unit and a second bridge unit disposed over the first bridge unit. The first semiconductor die is disposed over the substrate and overlaps the bridge structure. The first memory component is disposed over the substrate and overlaps the bridge structure, and it is adjacent to the first semiconductor die. The second memory component is disposed over the substrate and overlaps the bridge structure, and it is adjacent to the first memory component.

In accordance with some embodiments, the bridge structure has a first layer and a second layer disposed over the first layer. The first bridge unit is positioned in the first layer, and the second bridge unit is positioned in the second layer.

In accordance with some embodiments, the bridge structure further includes a conductive via positioned in the second layer. The first semiconductor die is coupled to the first bridge unit through the conductive via.

In accordance with some embodiments, the bridge structure further includes a dielectric material surrounding the second bridge unit. The conductive via penetrates the dielectric material.

In accordance with some embodiments, the bridge structure further includes a dummy die positioned in the second layer. The dummy die is adjacent to the second bridge unit. The dielectric material surrounds the dummy die.

In accordance with some embodiments, the first bridge unit has a dimension greater than that of the second bridge unit.

In accordance with some embodiments, the conductive via penetrates the second bridge unit.

In accordance with some embodiments, the first semiconductor die is coupled to the first memory component through the second bridge unit. The first semiconductor die is coupled to the second memory component through the first bridge unit.

In accordance with some embodiments, the first bridge unit overlaps the first semiconductor die, the first memory component, and the second memory component.

In accordance with some embodiments, the second bridge unit overlaps the first semiconductor die, and the first memory component.

Embodiments provide a semiconductor package structure. The semiconductor package structure includes a substrate, an interposer, a bridge structure, a first semiconductor die, a first memory component, and a second memory component. The interposer is disposed over the substrate. The bridge structure is embedded in the interposer. The bridge structure includes a first bridge unit and a second bridge unit disposed over the first bridge unit. The first semiconductor die is disposed over the interposer and overlaps the bridge structure. The first memory component is disposed over the interposer and overlaps the bridge structure, and it is adjacent to the first semiconductor die. The second memory component is disposed over the interposer and overlaps the bridge structure, and it is adjacent to the first memory component.

In accordance with some embodiments, the bridge structure has a first layer and a second layer disposed over the first layer. The first bridge unit is positioned in the first layer, and the second bridge unit is positioned in the second layer.

In accordance with some embodiments, the bridge structure further includes a first conductive via and a second conductive via. The first conductive via penetrates the first bridge unit. The second conductive via penetrates the second bridge unit.

In accordance with some embodiments, the bridge structure further includes a dielectric material and a third conductive via. The dielectric material surrounds the second bridge unit. The third conductive via penetrates the dielectric material. The first semiconductor die is coupled to the first bridge unit through the third conductive via.

In accordance with some embodiments, the first semiconductor die is coupled to the first memory component through the second bridge unit. The first semiconductor die is coupled to the second memory component through the first bridge unit.

In accordance with some embodiments, the semiconductor package structure further includes a passive component disposed within the interposer.

In accordance with some embodiments, the semiconductor package structure further includes conductive connectors disposed between the substrate and the interposer. The interposer is coupled to the substrate through the conductive connectors.

Embodiments provide a semiconductor package structure. The semiconductor package structure includes a substrate, an interposer, a bridge structure, a first semiconductor die, a first memory component, and a second memory component. The interposer is disposed over the substrate. The interposer includes a first layer and a second layer disposed over the first layer. The bridge structure is embedded in the interposer. The bridge structure includes a first bridge unit and a second bridge unit respectively disposed in the first layer and the second layer. The first semiconductor die is disposed over the interposer and overlaps the bridge structure. The first memory component is disposed over the interposer and overlaps the bridge structure, and it is adjacent to the first semiconductor die. The second memory component is disposed over the interposer and overlaps the bridge structure, and it is adjacent to the first memory component.

In accordance with some embodiments, the interposer further includes a conductive via positioned in the second layer. The first semiconductor die is coupled to the first bridge unit through the conductive via.

In accordance with some embodiments, the conductive via penetrates the second layer of the interposer.

In accordance with some embodiments, the bridge structure further includes a dummy die positioned in the second layer. The dummy die is adjacent to the second bridge unit.

In accordance with some embodiments, the first bridge unit has a dimension greater than that of the dummy die.

In accordance with some embodiments, the semiconductor package structure further includes another bridge structure and a second semiconductor die. The other bridge structure is embedded in the interposer. The second semiconductor die is disposed over the interposer. The first semiconductor die and the second semiconductor die overlap the other bridge structure.

In accordance with some embodiments, the other bridge structure is disposed in the second layer of the interposer.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package structure (10), comprising:
a substrate (102);
a bridge structure (204B) embedded in the substrate (102), wherein the bridge structure (204B) comprises a first bridge unit (BU1) and a second bridge unit (BU2) disposed over the first bridge unit (BU1);
a first semiconductor die (300-1, 300-2) disposed over the substrate (102) and overlapping the bridge structure (204B);
a first memory component (400-1, 400-3) disposed over the substrate (102) and overlapping the bridge structure (204B) and adjacent to the first semiconductor die (300-1, 300-2); and
a second memory component (400-1, 400-3) disposed over the substrate (102) and overlapping the bridge structure (204B) and adjacent to the first memory component (400-1, 400-3).

2. The semiconductor package structure (10) as claimed in claim 1, wherein the bridge structure (204B) has a first layer (204B-a) and a second layer (204B-b) disposed over the first layer (204B-a), the first bridge unit (BU1) is positioned in the first layer (204B-a), and the second bridge unit (BU2) is positioned in the second layer (204B-b).

3. The semiconductor package structure (10) as claimed in claim 2, wherein the bridge structure (204B) further comprises a conductive via (204v) positioned in the second layer (204B-b), and the first semiconductor die (300-1) is coupled to the first bridge unit (BU1) through the conductive via (204v).

4. The semiconductor package structure (10) as claimed in claim 3, wherein the bridge structure (204B) further comprises a dielectric material (204i) surrounding the second bridge unit (BU2), and the conductive via (204v) penetrates the dielectric material (204i).

5. The semiconductor package structure (10) as claimed in claim 4, wherein the bridge structure (204B) further comprises a dummy die (DM) positioned in the second layer (204B-b) and adjacent to the second bridge unit (BU2), and the dielectric material (204i) surrounds the dummy die (DM); and wherein the first bridge unit (BU1) has a dimension greater than that of the second bridge unit (BU2).

6. The semiconductor package structure (10) as claimed in claim 3, wherein the conductive via (204v) penetrates the second bridge unit (BU2).

7. The semiconductor package structure (10) as claimed in claim 1, wherein the first semiconductor die (300-1) is coupled to the first memory component (400-1) through the second bridge unit (BU2), and the first semiconductor die (300-1) is coupled to the second memory component (400-2) through the first bridge unit (BU1).

8. The semiconductor package structure (10) as claimed in claim **1,** wherein the first bridge unit (BU1) overlaps the first semiconductor die ( 300-1), the first memory component (400-1), and the second memory component (400-2); and/or wherein the second bridge unit (BU1) overlaps the first semiconductor die (300-1), and the first memory component (400-1).

9. A semiconductor package structure (20), comprising:
a substrate (102);
an interposer (202) disposed over the substrate (102);
a bridge structure (204B) embedded in the interposer (202), wherein the bridge structure (204B) comprises a first bridge unit (BU1) and a second bridge unit (BU2) disposed over the first bridge unit (BU1);
a first semiconductor die (300-1; 300-2) disposed over the interposer (202) and overlapping the bridge structure (204B);
a first memory component (400-1; 400-3) disposed over the interposer (202) and overlapping the bridge structure (204B) and adjacent to the first semiconductor die (300-1; 300-2); and
a second memory component (400-2; 400-4) disposed over the interposer (202) and overlapping the bridge structure (204B) and adjacent to the first memory component (400-1; 400-3).

10. The semiconductor package structure (20) as claimed in claim 9, wherein the bridge structure (204B) has a first layer (202B-a) and a second layer (204B-b) disposed over the first layer (202B-a), the first bridge unit (BU1) is positioned in the first layer (204B-a), and the second bridge unit (BU1) is positioned in the second layer (204B-b).

11. The semiconductor package structure (20) as claimed in claim 10, wherein the bridge structure (204B) further comprises a first conductive via (204v'-1) penetrating the first bridge unit (BU1) and a second conductive via (204v'-2) penetrating the second bridge unit (BU2); and wherein the bridge structure (204B) further comprises a dielectric material (204i) surrounding the second bridge unit (BU2) and a third conductive via (204v) penetrating the dielectric material (204i), and the first semiconductor die (300-1) is coupled to the first bridge unit through the third conductive via (204v).

12. The semiconductor package structure (20) as claimed in claim 9, further comprising:
a passive component (220) disposed within the interposer (202); and
conductive connectors (206) disposed between the substrate (102) and the interposer (202),
wherein the interposer (202) is coupled to the substrate (102) through the conductive connectors (206).

13. A semiconductor package structure (30), comprising:
a substrate (102);
an interposer (202) disposed over the substrate (102) and comprising a first layer (202-a) and a second layer (202-b) disposed over the first layer (202-a);
a bridge structure (204B) embedded in the interposer (202), wherein the bridge structure (204B) comprises a first bridge unit (BU1) and a second bridge unit (BU2) respectively disposed in the first layer (202-a) and the second layer (202-b);
a first semiconductor die (300-1, 300-2) disposed over the interposer (202) and overlapping the bridge structure (204B);
a first memory component (400-1, 400-3) disposed over the interposer (202) and overlapping the bridge structure (204B) and adjacent to the first semiconductor die (300-1, 300-2); and
a second memory component (400-2, 400-4) disposed over the interposer (202) and overlapping the bridge structure (204B) and adjacent to the first memory component (400-1, 400-3).

14. The semiconductor package structure (30) as claimed in claim 13, wherein the interposer (202) further comprises a conductive via (204v) positioned in the second layer (202-b), and the first semiconductor die (300-1) is coupled to the first bridge unit (BU1) through the conductive via (204v); and wherein the conductive via (204v) penetrates the second layer (202-b) of the interposer (202).

15. The semiconductor package structure (30) as claimed in claim 13, further comprising:
another bridge structure (204A) embedded in the interposer (202); and
a second semiconductor die (300-2) disposed over the interposer (202),
wherein the first semiconductor die (300-1) and the second semiconductor die (300-2) overlap the other bridge structure (204A); and
wherein the other bridge structure (204A)is disposed in the second layer (202-b) of the interposer (202).
